# EUROPEAN PATENT SPECIFICATION

(11) **EP 2 669 396 B1**
(45) Date of publication and mention of the grant of the patent: **27.05.2015**
(21) Application number: 11856829.4
(22) Date of filing: 27.01.2011
(51) Int. Cl.: C22C 21/02, C22F 1/043

(54) **HIGH ELECTRIC RESISTANCE ALUMINUM ALLOY**
ALUMINIUMLEGIERUNG MIT HOHEM ELEKTRISCHEM WIDERSTAND
ALLIAGE D'ALUMINIUM À RÉSISTANCE ÉLECTRIQUE ÉLEVÉE

(43) Date of publication of application: 04.12.2013
(73) Proprietor: Nippon Light Metal Co., Ltd., Tokyo 140-8628 (JP)
(72) Inventor: SUZUKI Satoru, Shizuoka-shi Shizuoka 421-3291 (JP); KISHIMOTO Atsushi, Shizuoka-shi Shizuoka 421-3291 (JP); ZHAO Pizhi, Shizuoka-shi Shizuoka 421-3291 (JP); ODA Kazuhiro, Shizuoka-shi Shizuoka 421-3291 (JP); ISOBE Tomohiro, Shizuoka-shi Shizuoka 421-3291 (JP)
(74) Representative: Potter Clarkson LLP
(86) International application number: PCT/JP2011/051615
(87) International publication number: WO 2012/101805

(56) References cited:
- EP-A1- 1 997 924
- CN-A- 101 045 970
- GB-A- 2 421 735
- JP-A- 2 232 331
- JP-A- 6 271 966
- JP-A- H02 232 331
- JP-A- 2004 143 511
- JP-A- 2005 139 496
- JP-A- 2006 183 122
- JP-A- 2007 070 716
- JP-A- 2008 291 364
- US-A- 4 104 089

## Description

### TECHNICAL FIELD

The present invention relates in general to a high electrical resistance aluminum alloy, more specifically to a high electrical resistance aluminum alloy casting excelling in toughness and corrosion resistance, suitable for use in the production of housings for electric motors, and a method for production thereof.

### BACKGROUND ART

AC electric motors are often used as motive power sources. AC electric motors consist of a stator and a rotor, and can be largely divided between induction motors using electromagnets in both the stator and the rotor, and synchronous motors using an electromagnet in either the stator or the rotor, and a permanent magnet in the other.

The stator and rotor in an induction motor are constituted by coil elements that both generate magnetic flux and a core element that concentrates the magnetic flux generated by the coil elements. When a current is supplied to at least one of the coil elements of the stator and rotor, a magnetic field is created in accordance with the laws of electromagnetic induction, setting up a magnetic flux between the stator and the rotor, and generating a rotational force on the rotor.

While the stators or rotors with the electromagnets in synchronous motors have the same structure as those of induction motors, the stators or rotors with the permanent magnets are constituted by a magnet element that generates magnetic flux and a core element for concentrating the magnetic flux generated by the magnet element. In the case of synchronous motors as well, when a current is supplied to a coil element of a stator or rotor using an electromagnet, a magnetic field is created in accordance with the laws of electromagnetic induction, setting up a magnetic flux between the stator and the rotor, and generating a rotational force on the rotor.

In the case of both the induction motor and the synchronous motor, the magnetic flux created by the magnetic field generated in accordance with the laws of electromagnetic induction is not limited to being between the stator and the rotor, and some leaks to the periphery thereof. For this reason, if the housing of the motor has good electroconductivity, eddy currents will be generated at the housing, resulting in eddy current loss and the housing being heated to high temperatures.

In view of these circumstances, Patent Document 1, for example, discloses art to improve the heat dissipation by using an aluminum alloy of high thermal conductivity in the housing. On the other hand, Patent Document 2 proposes art for reducing generated eddy currents by providing apertures at the portions of the housing where eddy currents occur or using a ceramic or resin that is non-magnetic and of high electrical resistivity as the housing. Additionally, Patent Document 3 proposes an aluminum alloy of high electrical resistivity capable of being used as the housing of an electric motor.

However, while the aluminum alloy disclosed in Patent Document 1 excels in heat dissipation, no measures are taken against eddy current loss, so the problem of reduced output of the electric motor accompanying the generation of eddy currents is not resolved.

Additionally, of the inventions disclosed in Patent Document 2, those having apertures at the portions where the eddy currents are generated have the problems that extra steps are required to make the apertures and the presence of the apertures reduces the rigidity of the housing. On the other hand, those using a ceramic or resin that is non-magnetic and having a high electrical resistivity cannot easily achieve toughness.

Furthermore, while the aluminum alloy disclosed in Patent Document 3 has sufficiently high electrical resistivity and is capable of solving the problem remaining in the invention of Patent Document 2, research by the present inventors etc. has revealed that it has insufficient strength, toughness and corrosion resistance for use as housings for electric motors, and presents economical problems for containing large quantities of expensive Mn, Mg and Cu.
Patent Document 1: JP 2004-277853 A
Patent Document 2: JP 2005-198463 A
Patent Document 3: JP 2005-139496 A

### SUMMARY OF THE INVENTION

The present invention was conceived in order to solve the above-described problems, and has the main purpose of offering a high electrical resistance aluminum alloy casting capable of being favorably used for the production of an electric motor housing, and a method for production thereof.

Additionally, the present invention offers an electric motor housing formed by the above-described aluminum alloy casting.

In one aspect of the present invention, a high electrical resistance aluminum alloy casting with excellent toughness and corrosion resistance, characterized by comprising 11.0 to 13.0 mass% of Si, 0.2 to 1.0 mass% of Fe, 0.2 to 2.2 mass% of Mn, 0.7 to 1.3 mass% of Mg, 0.5 to 1.3 mass% of Cr and 0.1 to 0.5 mass% of Ti, the balance consisting of Al and unavoidable impurities, wherein the amount of Cu as an unavoidable impurity is restricted to 0.2 mass% or less is offered. Additionally, in another aspect, an electric motor housing formed by the aluminum alloy casting is offered.

In this case, the aluminum alloy casting is preferably cast by any process among gravity casting, low-pressure casting, die casting and squeeze casting. The aluminum alloy casting may be presented for use without subjecting to a heat treatment after casting, or may be subjected to a heat treatment after casting. In one embodiment, the high electrical resistance aluminum alloy casting of the present invention is subjected after casting to a solution heat treatment at 510 to 530 °C for 2 to 5 hours, followed by artificial ageing at 160 to 200 °C for 4 to 8 hours.

In a further aspect of the present invention, a method for producing a high electrical resistance aluminum alloy casting with excellent toughness and corrosion resistance, characterized by casting an aluminum alloy melt comprising 11.0 to 13.0 mass% of Si, 0.2 to 1.0 mass% of Fe, 0.2 to 2.2 mass% of Mn, 0.7 to 1.3 mass% of Mg, 0.5 to 1.3 mass% of Cr and 0.1 to 0.5 mass% of Ti, the balance consisting of Al and unavoidable impurities, wherein the amount of Cu as an unavoidable impurity is restricted to 0.2 mass% or less is offered.

In this case, the casting is preferably cast by any process among gravity casting, low-pressure casting, die casting and squeeze casting. Additionally, the aluminum alloy casting may be followed by a heat treatment, or not followed by a heat treatment. In one embodiment, the method includes steps, after casting, of performing a solution heat treatment at 510 to 530 °C for 2 to 5 hours, followed by artificial ageing at 160 to 200 °C for 4 to 8 hours. In one example, the aluminum alloy casting to be produced is a housing for electric motors.

The aluminum alloy casting of the present invention has a high electrical resistivity and excels in toughness, and can therefore be favorably used as a housing for electric motors.

### BRIEF DESCRIPTION OF THE DRAWINGS

Fig. 1 is a diagram showing the shape of a tension testing piece for evaluating the strength properties of an example.
Fig. 2 is a diagram for explaining an offset method for calculating the 0.2% proof stress of an example.
Fig. 3 is a diagram showing the shape of a testing piece for evaluating the toughness of an example.
Fig. 4 is a diagram showing the shape of a hammer for evaluating the toughness of an example.
Fig. 5 is a diagram showing the shape of a testing piece for evaluating the corrosion resistance of an example.
Fig. 6 is a diagram showing the shape of a testing piece for evaluating the electrical resistivity of an example.
Fig. 7 is a microscope photograph showing the metal structure of an aluminum alloy testing material 3 according to an example of the present invention shown in the examples, after subjecting the testing material to a solution heat treatment for 3 hours at 520 °C, water-cooling, and subjecting to artificially ageing for 6 hours at 180 °C.
Fig. 8 is a microscope photograph showing the metal structure of an aluminum alloy testing material 19 according to an example of the present invention shown in the examples, after subjecting the testing material to a solution heat treatment for 3 hours at 520 °C, water-cooling, and subjecting to artificially ageing for 6 hours at 180°C.

### MODES FOR CARRYING OUT THE INVENTION

The present inventors performed diligent research into means for cheaply raising the electrical resistivity of high strength, high toughness, high corrosion resistance aluminum alloys capable of being favorably used as housings for electric motors. In the process of doing so, they found that an aluminum alloy with high corrosion resistance and high electrical resistivity can be obtained by adding an appropriate amount of Fe and Mn to an Al-Si type alloy. Furthermore, they discovered that by adding Mg, Cr or Ti, the electrical resistance can be further increased, the strength and toughness can be improved, and the corrosion resistance can be improved due to refinement of the crystal grains, thereby achieving the present invention.

One embodiment of the present invention relates to a high electrical resistance Al-Si type alloy with excellent toughness and corrosion resistance, comprising 11.0 to 13.0 mass% of Si, 0.2 to 1.0 mass% of Fe, 0.2 to 2.2 mass% of Mn, 0.7 to 1.3 mass% of Mg, 0.5 to 1.3 mass% of Cr and 0.1 to 0.5 mass% of Ti, the balance consisting of Al and unavoidable impurities, wherein the amount of Cu as an unavoidable impurity is restricted to 0.2 mass% or less. Additionally, another embodiment of the present invention relates to a high electrical resistance Al-Si type alloy casting with excellent toughness and corrosion resistance, comprising 11.0 to 13.0 mass% of Si, 0.2 to 1.0 mass% of Fe, 0.2 to 2.2 mass% of Mn, 0.7 to 1.3 mass% of Mg, 0.5 to 1.3 mass% of Cr and 0.1 to 0.5 mass% of Ti, the balance consisting of Al and unavoidable impurities, wherein the amount of Cu as an unavoidable impurity is restricted to 0.2 mass% or less.

Another embodiment of the present invention relates to the use of an alloy comprising 11.0 to 13.0 mass% of Si, 0.2 to 1.0 mass% of Fe, 0.2 to 2.2 mass% of Mn, 0.7 to 1.3 mass% of Mg, 0.5 to 1.3 mass% of Cr and 0.1 to 0.5 mass% of Ti, the balance consisting of Al and unavoidable impurities, wherein the amount of Cu as an unavoidable impurity is restricted to 0.2 mass% or less, or a casting of said alloy, as a high electrical resistance material with excellent toughness and corrosion resistance. Furthermore, another embodiment of the present invention relates to the use of an alloy comprising 11.0 to 13.0 mass% of Si, 0.2 to 1.0 mass% of Fe, 0.2 to 2.2 mass% of Mn, 0.7 to 1.3 mass% of Mg, 0.5 to 1.3 mass% of Cr and 0.1 to 0.5 mass% of Ti, the balance consisting of Al and unavoidable impurities, wherein the amount of Cu as an unavoidable impurity is restricted to 0.2 mass% or less, or a casting of said alloy, for producing a high electrical resistance material with excellent toughness and corrosion resistance.

First, the functions of each component element constituting the aluminum alloy will be discussed briefly.

### Si: 11.0 to 13.0 mass%

The addition of Si up to the eutectic point in the Al-Si system has the effects of improving the strength, toughness, and castability without detracting from the corrosion resistance, so in the present invention, it is added within the range up to the eutectic point. In an Al-Si two-element equilibrium diagram, the eutectic composition is Al-12.6 mass% Si, but the alloy of the present invention includes 0.7 to 1.3 mass% of Mg. When 0.7 mass% of Mg is added, the eutectic point is Al-13.1 mass% Si, and when 1.3 mass% of Mg is added, the eutectic point is Al-13.8 mass% Si, so the amount of Si added to the alloy of the present invention, 11.0 to 13.0 mass%, is less than that of the eutectic point. When the amount of Si added is less than 11.0 mass%, the effect of improving the strength, toughness and castability is insufficient and therefore undesirable. On the other hand, the addition of Si past the eutectic point reduces castability due to increases in the liquidus temperature and also reduces toughness since the primary crystals are of Si, which is undesirable.

### Fe: 0.2 to 1.0 mass%

In an Al-based cast alloy, the addition of 0.2 to 1.0 mass% of Fe has an effect of preventing burning to the cast when casting, as well as raising the strength and increasing the electrical resistance, so it is added within that range to the present invention. If the amount of Fe added is less than 0.2 mass%, the effect of preventing burning to the cast when casting is insufficient, and no significant strength increasing effect is observed, which is undesirable. On the other hand, if the amount of Fe in the Al-Si type alloy exceeds 1.0 mass%, crude intermetallic compounds are generated in the Al-Fe-Si system, making it brittle and reducing toughness, which is undesirable.

### Mn: 0.2 to 2.2 mass%

In Al-based alloys, the addition of 0.2 to 2.2 mass% of Mn maintains the corrosion resistance, improves strength and increases electrical resistance. Additionally, the addition of 0.2 to 2.2 mass% of Mn to an Al-Si type alloy containing 0.2 to 1.0 mass% of Fe contributes to improved toughness, but the addition of Mn in excess of 2.2 mass% causes brittleness along with the creation of crude intermetallic compounds in the Al-Mn-Si system, thereby reducing the toughness, so in the present invention, the amount of Mn added is in the range of 0.2 to 2.2 mass%. If the amount of Mn added is less than 0.2 mass%, significant strength improving effects, toughness improving effects and electrical resistance increasing effects are not observed, which is undesirable. On the other hand, as mentioned previously, if the amount of Mn added exceeds 2.2 mass%, the toughness is reduced, which is undesirable.

### Mg: 0.7 to 1.3 mass%

In an Al-Si type alloy, the addition of 0.7 to 1.3 mass% of Mg has a strength improving effect with the addition, and an even greater strength improving effect and electrical resistance increasing effect due to a heat treatment for artificial ageing to be described in detail below, so it is added to the present invention in the indicated range. If the amount of Mg added is less than 0.7 mass%, the aforementioned effects are insufficient, which is undesirable. On the other hand, if the amount of Mg added exceeds 1.3 mass%, the aforementioned effects reach saturation, while further addition is a factor in reducing castability due to the formation of oxides (in the melt) during casting, as well as raising the cost, which is undesirable.

### Cr: 0.5 to 1.3 mass%; Ti: 0.1 to 0.5 mass%

The addition of Cr and Ti to an Al-based alloy has the effect of increasing electrical resistance, improving the strength and toughness due to crystal grain refinement, and improving corrosion resistance. Therefore, in the present invention, Cr is added in the range of 0.5 to 1.3 mass% and Ti is added in the range of 0.1 to 0.5 mass%. If the amount of Cr added is less than 0.5 mass%, or the amount of Ti added is less than 0.1 mass%, then a significant toughness improving effect, strength improving effect and corrosion resistance improving effect is not observed, which is undesirable. On the other hand, if the amount of Cr added exceeds 1.3 mass%, the formation of crude Al-Cr type intermetallic compounds reduces the toughness, which is undesirable. Additionally, if the amount of Ti added exceeds 0.5 mass%, the toughness improving effect, strength improving effect and corrosion resistance improving effect are saturated, and further addition results in increased cost, which is undesirable.

### Other Elements

While Cu conventionally has been added to Al-Si type alloys for the purpose of improving strength, the addition of Cu, while effective in improving strength, reduces the toughness and the corrosion resistance. For this reason, in the present invention, various types of melt raw materials such as ingots, scrap and added alloys are selected, and the content of Cu as an impurity is held to 0.2 mass% or less, preferably 0.1 mass% or less, more preferably 0.05 mass% or less, and most preferably 0.01 mass% or less. Thus, the lower the Cu content the better, but on the other hand, the use of aluminum ingots of low Cu content raises the cost, so the melt raw material should be chosen in consideration of the effects and the cost.

While other elements may be included as unavoidable impurities in aluminum ingots, they will not detract from the effects of the present invention if only present up to 0.1 mass% individually and 0.3 mass% in total, so their presence in this range is tolerable.

### [Production Method]

Another embodiment of the present invention relates to an aluminum alloy casting production method characterized by casting an aluminum alloy melt comprising 11.0 to 13.0 mass% of Si, 0.2 to 1.0 mass% of Fe, 0.2 to 2.2 mass% of Mn, 0.7 to 1.3 mass% of Mg, 0.5 to 1.3 mass% of Cr and 0.1 to 0.5 mass% of Ti, with the balance consisting of Al and unavoidable impurities, wherein the content of Cu as an unavoidable impurity is 0.2 mass% or less. As disclosed in the above-identified Patent Document 1 and Patent Document 3, electric motor housings of aluminum alloy have conventionally been produced by known casting methods such as gravity casting, low-pressure casting, die casting and squeeze casting, and these casting methods can also be favorably used in carrying out the present invention.

The aluminum alloy casting of the present invention has high strength, high toughness and high corrosion resistance, as well as high electrical resistance, even directly as cast, so it can be favorably used as a housing for an electric motor, but by performing heat treatments for artificial ageing, the strength and corrosion resistance can be further improved, which is favorable.

The heat treatment for artificial ageing should preferably be for 4 to 8 hours at 160 to 200 °C. If the heat treatment temperature is less than 160 °C or the heat treatment time is less than 4 hours, there is little precipitation of fine intermetallic compounds during the heat treatment, so the improvement in strength due to the artificial ageing treatment is inadequate, and there is little significant difference from the case where a heat treatment for artificial ageing is not performed. On the other hand, if the heat treatment temperature exceeds 200 °C or the heat treatment time exceeds 8 hours, the precipitated intermetallic compounds can grow too large, resulting in so-called over-ageing, thereby reducing the strength improving effect and reducing the electrical resistivity, which is undesirable.

Furthermore, in the present invention, it is preferable to carry out a heat treatment for solutionization after casting and before said artificial ageing. By carrying out a heat treatment for solutionization, the variability in properties can be reduced. The heat treatment for solutionization should preferably be performed for 2 to 5 hours at 510 to 530 °C. If the heat treatment temperature is less than 510 °C or the heat treatment time is less than 2 hours, the solutionization effect is insufficient, and there is little significant difference from the case where a heat treatment is not carried out for solutionization, which is undesirable. On the other hand, the heat treatment for solutionization is adequate if carried out for 5 hours at 530 °C, and it is meaningless to carry out the heat treatment in excess of this temperature and time, which is undesirable.

Additionally, when producing a housing for an electric motor, it is preferable to perform machining after casting, but when carrying out a heat treatment for ageing as described above, the machining should precede the ageing step.

Aside for use in housings for electric motors, the aluminum alloy casting of the present invention can be favorably used in any application requiring a material of high strength, high toughness and high corrosion resistance, while also having high electrical resistivity.

### EXAMPLES

While the present invention will be explained by way of examples in detail below, the present invention is not to be construed as being limited by these examples.

The respective properties in the examples were evaluated by the following methods.

### (1) Strength

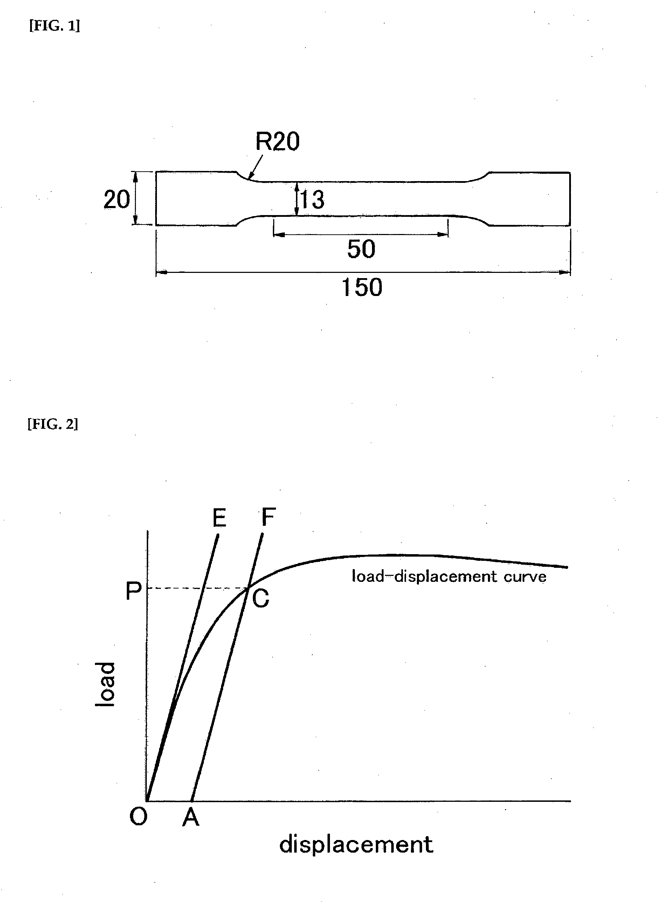

The strength was evaluated by a so-called tension testing method. That is, tension testing pieces in the shape shown in Fig. 1 were prepared from the testing materials by cutting, and the tensile strength, 0.2% proof stress and break elongation at room temperature were measured with the distance between gripping devices set at 75 mm and the tension speed set at 2.0 mm/min. At this time, the 0.2% proof stress was calculated by an offset method. Given the relationship between load and displacement shown in Fig. 2, the tangent OE at the elastic deformation region of the load-displacement curve exhibiting a linear relationship between load and displacement and the parallel line AF parallel to the tangent OE but with the displacement offset by 0.2% were drawn, the intersection point C between the parallel line AF and the load-displacement curve was determined, and the 0.2% proof stress was calculated from the load P at intersection point C.

### (2) Toughness

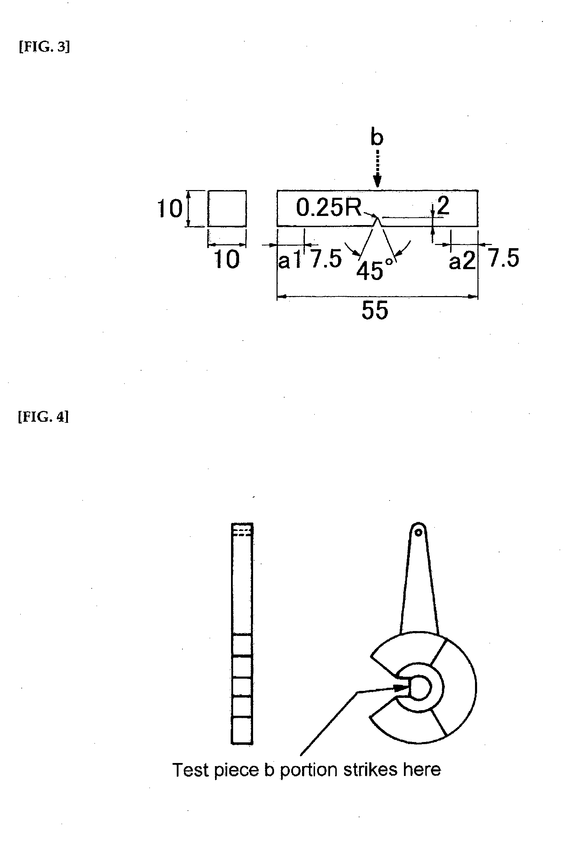

The toughness was evaluated by a so-called Charpy impact test. That is, a testing piece having a notch shape forming a V-notch as shown in Fig. 3 was prepared from the testing materials by cutting, and while supporting the two points a1 and a2 in Fig. 3 at room temperature so as to be unable to move in the direction b and to be able to freely move in directions other than b, a hammer of the shape shown in Fig. 4 with a mass of 26 kg was made to impact point b in the impact direction of the test piece shown in Fig. 3 at a speed of 4.0102 m/s, breaking the testing piece by the impact, and the difference in kinetic energy of the hammer before and after breaking the testing piece was measured as the energy absorbed when the testing piece broke, the Charpy impact value being computed from the absorbed energy.

### (3) Corrosion Resistance

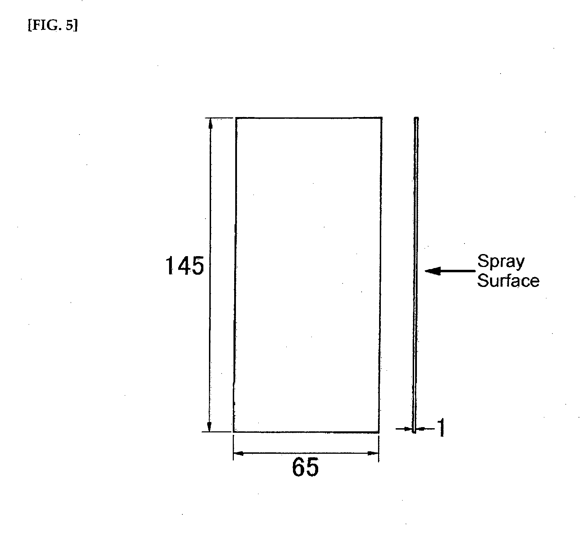

The corrosion resistance was evaluated in accordance with the so-called salt spray test. That is, the test was performed by preparing a 65 × 145 × 1.0 mm test piece as shown in Fig. 5 from the testing materials by cutting, while dissolving 1 cm³ of acetic anhydride and 0.26 g of copper(II) chloride dihydrate in a 5 mass% sodium chloride aqueous solution that was prepared beforehand to form a test solution, and spraying this test solution onto the surface of the test piece marked "spray surface" in Fig. 5 at a flow rate of 1.5 cm³/(80 cm²·h), after which the change in mass of the test piece before and after the test was evaluated.

### (4) Electrical Resistivity

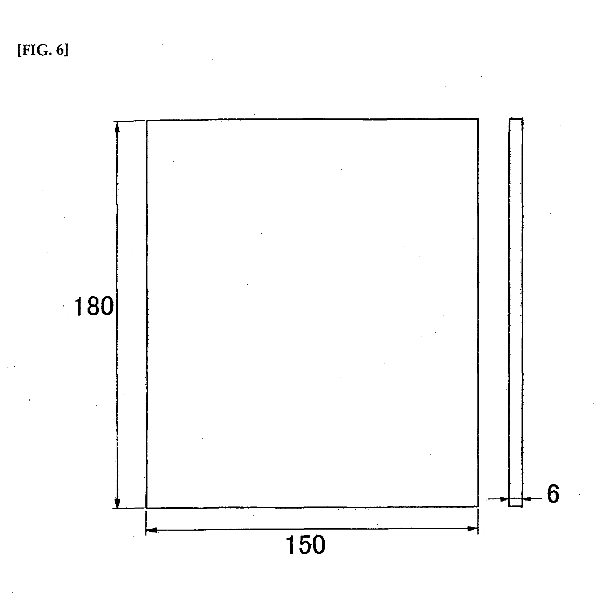

The electrical resistivity was obtained by preparing a 180 × 150 × 6 mm test piece as shown in Fig. 6 from each test material, measuring the electrical conductivity with an eddy current type conductivity meter (product name Autosigma 3000; General Electric Company (CT, USA)), and computed from the measurement value.

### <Preparation of Aluminum Alloy Test Materials>

As shown in Table 1 below, aluminum alloy test materials of Alloy Nos. 1-6 (Present Invention Examples) which are aluminum alloy castings with compositions within the scope of the present invention, aluminum alloy test materials of Alloy Nos. 7-18 (Comparative Examples) which are aluminum alloy castings with compositions not within the scope of the present invention, and an aluminum alloy test material of Alloy No. 19 (Conventional Example) which is an aluminum alloy casting with a composition in the scope disclosed in Patent Document 3 were cast by a die casting method. The aluminum alloy test materials of Alloy Nos. 3-7 are present invention examples and comparative examples in which the Cu content is changed. The aluminum alloy test materials of Alloy Nos. 8-9 are comparative examples wherein Si is outside the scope of the present invention. The aluminum alloy test materials of Alloy Nos. 10-11 are comparative examples wherein Fe lies outside the scope of the present invention. The aluminum alloy test materials of Alloy Nos. 12-13 are comparative examples wherein Mn lies outside the scope of the present invention. The aluminum alloy test materials of Alloy Nos. 14-15 are comparative examples wherein Mg lies outside the scope of the present invention. The aluminum alloy test materials of Alloy Nos. 16-17 are comparative examples wherein Cr lies outside the scope of the present invention. The aluminum alloy test material of Alloy No. 18 is a comparative example wherein Ti lies outside the scope of the present invention.

**[Table 1]**

| Aluminum Alloy Composition (mass%) | | | | | | | | | |
|---|---|---|---|---|---|---|---|---|---|
| Alloy No. | Si | Fe | Cu | Mn | Mg | Cr | Ti | Al | Note |
| 1 | 12.0 | 0.54 | - | 1.38 | 0.99 | 0.70 | 0.20 | bal | Present Invention |
| 2 | 12.1 | 0.50 | - | 1.35 | 1.02 | 0.54 | 0.21 | bal | Present Invention |
| 3 | 12.1 | 0.52 | 0.01 | 1.36 | 1.00 | 0.54 | 0.21 | bal | Present Invention |
| 4 | 12.1 | 0.53 | 0.04 | 1.36 | 1.01 | 0.55 | 0.21 | bal | Present Invention |
| 5 | 12.2 | 0.51 | 0.07 | 1.34 | 1.02 | 0.56 | 0.20 | bal | Present Invention |
| 6 | 12.0 | 0.50 | 0.15 | 1.35 | 0.98 | 0.52 | 0.20 | bal | Present Invention |
| 7 | 12.1 | 0.52 | 0.60 | 1.33 | 1.02 | 0.52 | 0.20 | bal | Comparative Example |
| 8 | 10.3 | 0.52 | - | 1.37 | 0.99 | 0.54 | 0.20 | bal | Comparative Example |
| 9 | 14.1 | 0.51 | - | 1.35 | 0.98 | 0.52 | 0.20 | bal | Comparative Example |
| 10 | 12.0 | 0.12 | - | 1.37 | 1.02 | 0.55 | 0.20 | bal | Comparative Example |
| 11 | 12.1 | 1.20 | - | 1.35 | 0.99 | 0.53 | 0.21 | bal | Comparative Example |
| 12 | 12.2 | 0.50 | - | 0.14 | 1.02 | 0.54 | 0.21 | bal | Comparative Example |
| 13 | 12.0 | 0.50 | - | 3.10 | 1.00 | 0.55 | 0.20 | bal | Comparative Example |
| 14 | 12.1 | 0.50 | - | 1.33 | 0.35 | 0.56 | 0.21 | bal | Comparative Example |
| 15 | 12.0 | 0.52 | - | 1.32 | 1.80 | 0.55 | 0.20 | bal | Comparative Example |
| 16 | 7.2.1 | 0.50 | - | 1.35 | 0.99 | 0.25 | 0.21 | bal | Comparative Example |
| 17 | 12.1 | 0.51 | - | 1.36 | 1.00 | 1.90 | 0.21 | bal | Comparative Example |
| 18 | 1.2.2 | 0.51 | - | 1.38 | 1.04 | 0.54 | 0.04 | bal | Comparative Example |
| 19 | 10.8 | 0.15 | 4.81 | 2.36 | 5.12 | - | - | bal | Conventional Example |

| | | | | | | | | | |
|---|---|---|---|---|---|---|---|---|---|
| In the table, "-" indicates a value less than the lower limit of measurement (0.01 mass%) In the table, underlining indicates a value outside the range of the present invention. | | | | | | | | | |

For each of these nineteen different aluminum alloy test materials, samples were produced (a) directly as cast, and (b) subjected to a solution heat treatment at 520 °C for 3 hours, then water-cooled, followed by an artificial ageing treatment at 180 °C for 6 hours.

### <Evaluation of Properties of Aluminum Alloy Casting>

The above-described aluminum alloy test materials were each evaluated for the properties of strength, toughness, corrosion resistance and electrical resistivity in accordance with the evaluation methods described above.

Of these results, comparisons of Alloy No. 3 which is a representative of the present invention and Alloy No. 19 which is a conventional example are summarized in the following Tables 2-3.

**[Table 2]**

| (a) Evaluation of Properties of Test Materials as Cast | | | | | | | |
|---|---|---|---|---|---|---|---|
| Alloy No. | Tensite Test Properties | | | Charpy Impact (J/cm²) | Salt Spray Test Mass Change (µg) | Elect Resist (mΩm) | Note |
| | Tensile Strength (MPa) | 0.2% Proof Stress (MPa) | Break Elong (%) | | | | |
| 3 | 306 | 196 | 2.0 | 1.02 | 0.97 | 71.9 | Present Invention |
| 19 | 297 | 269 | 0.4 | 0.53 | 1.09 | 79.9 | Conventional Example |

**[Table 3]**

| (b) Evaluation of Properties of Test Materials after Solution Heat Treatment, Water-Cooling and Artificial Ageing | | | | | | | |
|---|---|---|---|---|---|---|---|
| Alloy No. | Tensile Test Properties | | | Charpy Impact (J/cm²) | Salt Spray Test Mass Change (µg) | Elect Resist (mΩm) | Note |
| | Tensile Strength (MPa) | 0.2% Proof Stress (MPa) | Break Elong (%) | | | | |
| 3 | 383 | 331 | 2.1 | 0.98 | 0.73 | 59.9 | Present Invention |
| 19 | 343 | - | 0.1 | 0.52 | 1.02 | 67.7 | Conventional Example |

| | | | | | | | |
|---|---|---|---|---|---|---|---|
| In the table, "-" indicates that the break elongation was less than 0.2% and therefore could not be measured. | | | | | | | |

According to the results shown in Tables 2 and 3, the aluminum alloy test materials of the present invention examples, whether (a) as cast, or (b) after subjecting to a solution heat treatment at 520 °C for 3 hours, then water-cooled and artificially aged at 180 °C for 6 hours, had slightly lower electrical resistivity but excellent strength, toughness and corrosion resistance compared to aluminum alloy test materials of conventional examples subjected to the same treatments. In other words, the aluminum alloy test material of the present invention had significantly high break elongation and Charpy values, as well as high tensile strength, and little mass change in the test material before and after neutral salt spray testing. An aluminum alloy casting having such properties can be favorably used as a housing for an electric motor.

Next, Alloy Nos. 1, 2 and 4-18 which are present invention examples and comparative examples when changing the Cu content and comparative examples where the Si, Fe, Ti, Mn, Mg or Cr is outside the range of the present invention are summarized in the following Tables 4-5.

**[Table 4]**

| (a) Evaluation of Properties of Test Materials as Cast | | | | | | | |
|---|---|---|---|---|---|---|---|
| Alloy No. | Tensile Test Properties | | | Charpy Impact (J/cm²) | Salt Spray Test Mass Change (µg) | Elect Resist (mΩm) | Note |
| | Tensile Strength (MPa) | 0.2% Proof Stress (MPa) | Break Elong (%) | | | | |
| 1 | 321 | 204 | 2.0 | 0.93 | 0.91 | 71.9 | Present Invention |
| 2 | 294 | 193 | 2.3 | 1.07 | 0.84 | 71.6 | Present Invention |
| 4 | 302 | 200 | 2.0 | 1.06 | 0.94 | 71.7 | Present Invention |
| 5 | 300 | 198 | 2.0 | 1.03 | 0.90 | 71.8 | Present Invention |
| 6 | 305 | 198 | 1.8 | 1.02 | 0.91 | 71.4 | Present Invention |
| 7 | 331 | 212 | 1.3 | 0.80 | 1.14 | 70.8 | Comparative Example |
| 8 | 320 | 209 | 2.5 | 1.14 | 0.98 | 70.3 | Comparative Example |
| 9 | 276 | 195 | 1.3 | 0.81 | 0.97 | 72.0 | Comparative Example |
| 10 | 318 | 194 | 2.6 | 1.19 | 0.98 | 68.9 | Comparative Example |
| 11 | 267 | 198 | 1.1 | 0.77 | 1.01 | 74.2 | Comparative Example |
| 12 | 318 | 193 | 2.5 | 1.11 | 0.99 | 67.7 : | Comparative Example |
| 13 | 282 | 197 | 1.3 | 0.82 | 0.98 | 73.3 | Comparative Example |
| 14 | 302 | 177 | 3.4 | 1.32 | 1.08 | 64.4 | Comparative Example |
| 15 | 313 | 232 | 1.3 | 0.79 | 0.85 | 76.1 | Comparative Example |
| 16 | 310 | 201 | 2.4 | 1.12 | 0.98 | 63.3 | Comparative Example |
| 17 | 289 | 183 | 1.2 | 0.76 | 0.95 | 74.8 | Comparative Example |
| 18 | 320 | 208 | 2.3 | 1.01 | 0.99 | 67.1 | Comparative Example |

| | | | | | | | |
|---|---|---|---|---|---|---|---|
| In the table, the underlines indicate that the Charpy impact was less than 0.90, the mass change before and after salt spray was more than 0.97 µg, or the electrical resistivity was less than 59.0 mΩm. | | | | | | | |

**[Table 5]**

| (b) Evaluation of Properties of Test Materials after Solution Heat Treatment, Water-Cooling and Artificial Ageing | | | | | | | |
|---|---|---|---|---|---|---|---|
| Alloy No. | Tensile Test Properties | | | Charpy Impact (J/cm²) | Salt Spray Test Mass Change (µg) | Elect Resist (mΩm) | Note |
| | Tensile Strength (MPa) | 0.2% Proof Stress (MPa) | Break Elong (%) | | | | |
| 1 | 384 | 332 | 2.0 | 1.00 | 0.79 | 61.3 | Present Invention |
| 2 | 361 | 314 | 2.3 | 1.06 | 0.81 | 59.8 | Present Invention |
| 4 | 377 | 326 | 2.1 | 1.00 | 0.78 | 60.2 | Present Invention |
| 5 | 380 | 328 | 2.0 | 0.98 | 0.83 | 60.4 | Present Invention |
| 6 | 370 | 318 | 2.1 | 1.00 | 0.89 | 59.5 | Present Invention |
| 7 | 393 | 335 | 1.5 | 0.79 | 1.16 | 58.9 | Comparative Example |
| 8 | 385 | 327 | 2.7 | 1.10 | 1.02 | 58.9 | Comparative Example |
| 9 | 346 | 307 | 1.2 | 0.82 | 0.98 | 60.0 | Comparative Example |
| 10 | 378 | 315 | 2.5 | 1.22 | 1.00 | 57.5 | Comparative Example |
| 11 | 334 | 320 | 0.9 | 0.78 | 1.00 | 62.8 | Comparative Example |
| 12 | 380 | 315 | 2.4 | 1.08 | 1.02 | 55.6 | Comparative Example |
| 13 | 345 | 316 | 1.4 | 0.80 | 0.99 | 61.0 | Comparative Example |
| 14 | 375 | 294 | 3.5 | 1.28 | 1.10 | 52.6 | Comparative Example |
| 15 | 381 | 355 | 1.4 | 0.80 | 0.82 | 64.2 | Comparative Example |
| 16 | 374 | 314 | 2.6 | 1.09 | 0.96 | 52.1 | Comparative Example |
| 17 | 357 | 305 | 1.4 | 0.79 | 0.93 | 63.1 | Comparative Example |
| 18 | 392 | 324 | 2.2 | 1.04 | 0.96 | 54.7 | Comparative Example |

| | | | | | | | |
|---|---|---|---|---|---|---|---|
| In the table, the underlines indicate that the Charpy impact was less than 0.90, the mass change before and after salt spray was more than 0.97 µg, or the electrical resistivity was less than 59.0 mΩm. | | | | | | | |

According to the results shown in these tables, when used (a) as cast, the aluminum alloy test materials of the present invention satisfied all the conditions of a Charpy impact value of at least 0.90, a mass change before and after salt spray of 0.97 µg or less, and an electrical resistivity of at least 59.0 mΩm, while the aluminum alloy test materials of the comparative examples had one of these properties outside the desired values, and when used (b) after subjecting to a solution heat treatment at 520 °C for 3 hours, then water-cooled and artificially aged at 180 °C for 6 hours, the aluminum alloy test materials of the present invention satisfied all the conditions of a Charpy impact value of at least 0.90, a mass change before and after salt spray of 0.97 µg or less, and an electrical resistivity of at least 59.0 mΩm, while the aluminum alloy test materials of the comparative examples had one of these properties outside the desired values. In other words, the aluminum alloy test materials of the present invention have a harmonious balance of the properties of strength, toughness, corrosion resistance and electrical resistivity. The aluminum castings having these properties are capable of being used favorably as housings for electric motors.

Additionally, the aluminum alloy test materials according to the present invention, when used directly as cast, have an electrical resistivity of at least 71.0 mΩm, and when subjected to solutionization and artificial ageing after casting, have a lower electrical resistivity than directly as cast, but have a tensile strength of at least 360 MPa, and a mass change before and after salt spray of 0.9 µg or less.

### <Observation of Metal Structure of Aluminum Alloy Casting>

Of the above test materials, the metal structures of the aluminum alloy test material of Alloy No. 3 according to the present invention (b) after subjecting to solutionization, water-cooling and artificial ageing, and the aluminum alloy test material of Alloy No. 19 according to a conventional example after likewise subjecting to solutionization, water-cooling and artificial ageing, were observed by microscope.

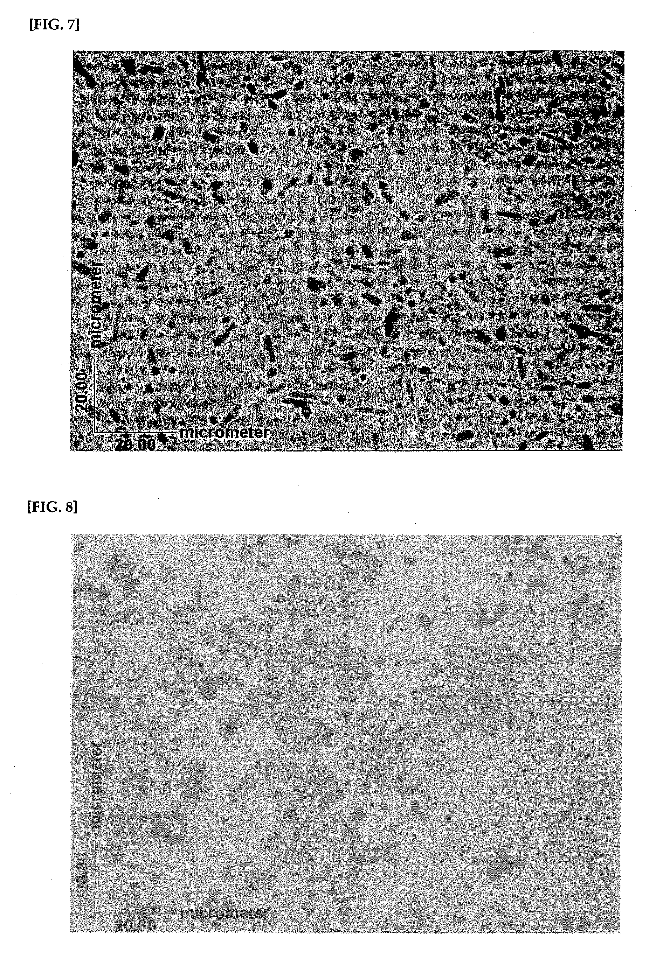

Fig. 7 shows the metal structure of an aluminum alloy test material of Alloy No. 3 according to the present invention and Fig. 8 shows the metal structure of an aluminum alloy test material of Alloy No. 19. As can be seen from these microscope photographs, in the aluminum alloy test material of Alloy No. 3 according to the present invention, the intermetallic compounds are very finely and uniformly dispersed, and no crude intermetallic compounds can be seen. On the other hand, with the aluminum alloy test material of Alloy No. 19 according to a conventional example, the presence of crude intermetallic compounds can be observed. The differences in tensile strength, break elongation and Charpy impact between these test materials shown in Table 3 are believed to be due to the differences in metal structure.

### INDUSTRIAL APPLICABILITY

The aluminum alloy castings of the present invention have high electrical resistivity, high toughness and high corrosion resistance, and are also lightweight, and can therefore be favorably used as housings in electric motors.

## Claims

1. A high electrical resistance aluminum alloy casting with excellent toughness, **characterized by** comprising 11.0 to 13.0 mass% of Si, 0.2 to 1.0 mass% of Fe, 0.2 to 2.2 mass% of Mn, 0.7 to 1.3 mass% of Mg, 0.5 to 1.3 mass% of Cr and 0.1 to 0.5 mass% of Ti, the balance consisting of Al and unavoidable impurities, wherein the amount of Cu as an unavoidable impurity is restricted to 0.2 mass% or less.

2. The aluminum alloy casting of claim 1, cast by any process among gravity casting, low-pressure casting, die casting and squeeze casting.

3. The aluminum alloy casting of claim 2, not subjected to a heat treatment after casting.

4. The aluminum alloy casting of claim 2, subjected after casting to a solution heat treatment at 510 to 530 °C for 2 to 5 hours, followed by artificial ageing at 160 to 200 °C for 4 to 8 hours.

5. An electric motor housing formed by the aluminum alloy casting of any one of claims 1 to 4.

6. A method for producing a high electrical resistance aluminum alloy casting with excellent toughness, **characterized by** casting an aluminum alloy melt comprising 11.0 to 13.0 mass% of Si, 0.2 to 1.0 mass% of Fe, 0.2 to 2.2 mass% of Mn, 0.7 to 1.3 mass% of Mg, 0.5 to 1.3 mass% of Cr and 0.1 to 0.5 mass% of Ti, the balance consisting of Al and unavoidable impurities, wherein the amount of Cu as an unavoidable impurity is restricted to 0.2 mass% or less.

7. The method for producing the aluminum alloy casting of claim 6, wherein the casting is by any process among gravity casting, low-pressure casting, die casting and squeeze casting.

8. The method for producing the aluminum alloy casting of claim 7, wherein a heat treatment is not performed after casting.

9. The method for producing the aluminum alloy casting of claim 7, wherein after casting, a solution heat treatment is performed at 510 to 530 °C for 2 to 5 hours, after which artificial ageing is performed at 160 to 200 °C for 4 to 8 hours.

10. The production method of any one of claims 6 to 9, wherein the aluminum alloy casting is a housing for an electric motor.

## Patentansprüche

1. Aluminiumlegierungsgussstück mit hohem elektrischem Widerstand und ausgezeichneter Festigkeit, **dadurch gekennzeichnet, dass** es 11,0 bis 13,0 Gew.-% Si, 0,2 bis 1,0 Gew.-% Fe, 0,2 bis 2,2 Gew.-% Mn, 0,7 bis 1,3 Gew.-% Mg, 0,5 bis 1,3 Gew.-% Cr und 0,1 bis 0,5 Gew.-% Ti umfasst, wobei der Rest aus Al und unvermeidbaren Verunreinigungen besteht, wobei die Menge an Cu als unvermeidbarer Verunreinigung auf 0,2 Gew.-% oder weniger beschränkt ist.

2. Aluminiumlegierungsgussstück nach Anspruch 1, das mit einem der Verfahren Schwerkraftgießen, Niederdruckgießen, Druckgießen und Pressgießen gegossen wird.

3. Aluminiumlegierungsgussstück nach Anspruch 2, das nach dem Gießen nicht wärmebehandelt wird.

4. Aluminiumlegierungsgussstück nach Anspruch 2, das nach dem Gießen 2 bis 5 Stunden bei 510 bis 530 °C lösungsgeglüht wird, gefolgt von 4 bis 8 Stunden künstlicher Alterung bei 160 bis 200 °C .

5. Elektromotorgehäuse, das durch das Aluminiumlegierungsgussstück nach einem der Ansprüche 1 bis 4 ausgebildet wird.

6. Verfahren zum Herstellen eines Aluminiumlegierungsgussstücks mit hohem elektrischem Widerstand und ausgezeichneter Festigkeit, **gekennzeichnet durch** das Gießen einer Aluminiumlegierungsschmelze, die 11,0 bis 13,0 Gew.-% Si, 0,2 bis 1,0 Gew.-% Fe, 0,2 bis 2,2 Gew.-% Mn, 0,7 bis 1,3 Gew.-% Mg, 0,5 bis 1,3 Gew.-% Cr und 0,1 bis 0,5 Gew.-% Ti umfasst, wobei der Rest aus Al und unvermeidbaren Verunreinigungen besteht, wobei die Menge an Cu als unvermeidbarer Verunreinigung auf 0,2 Gew.-% oder weniger beschränkt ist.

7. Verfahren zum Herstellen des Aluminiumlegierungsgussstücks nach Anspruch 6, wobei das Gießen mit einem der Verfahren Schwerkraftgießen, Niederdruckgießen, Druckgießen und Pressgießen erfolgt.

8. Verfahren zum Herstellen des Aluminiumlegierungsgussstücks nach Anspruch 7, wobei nach dem Gießen keine Wärmebehandlung erfolgt.

9. Verfahren zum Herstellen des Aluminiumlegierungsgussstücks nach Anspruch 7, wobei nach dem Gießen 2 bis 5 Stunden bei 510 bis 530 °C ein Lösungsglühen erfolgt, wonach bei 160 bis 200 °C 4 bis 8 Stunden lang eine künstliche Alterung erfolgt.

10. Herstellungsverfahren nach einem der Ansprüche 6 bis 9, wobei das Aluminiumlegierungsgussstück ein Gehäuse für einen Elektromotor ist.

## Revendications

1. Pièce coulée en alliage d'aluminium à résistance électrique élevée dotée d'une excellente ténacité, **caractérisée en ce qu'**elle comprend 11,0 à 13,0 % en masse de Si, 0,2 à 1,0 % en masse de Fe, 0,2 à 2,2 % en masse de Mn, 0,7 à 1,3 % en masse de Mg, 0,5 à 1,3 % en masse de Cr et 0,1 à 0,5 % en masse de Ti, le reste étant constitué par Al et des impuretés inévitables, dans laquelle la quantité de Cu en tant qu'impureté inévitable est limitée à 0,2 % en masse ou moins.

2. Pièce coulée en alliage d'aluminium selon la revendication 1, coulée par tout procédé parmi la coulée par gravité, la coulée basse pression, la coulée sous pression et le forgeage liquide.

3. Pièce coulée en alliage d'aluminium selon la revendication 2, non soumise à un traitement thermique après coulée.

4. Pièce coulée en alliage d'aluminium selon la revendication 2, soumise après coulée à un traitement thermique en solution à 510 à 530 °C pendant 2 à 5 heures, suivi d'un vieillissement artificiel à 160 à 200 °C pendant 4 à 8 heures.

5. Carte de moteur électrique formé par la pièce coulée en alliage d'aluminium de l'une quelconque des revendications 1 à 4.

6. Procédé de production d'une pièce coulée en alliage d'aluminium à résistance électrique élevée dotée d'une excellente ténacité, **caractérisé par** la coulée d'un bain d'alliage d'aluminium comprenant 11,0 à 13,0 % en masse de Si, 0,2 à 1,0 % en masse de Fe, 0,2 à 2,2 % en masse de Mn, 0,7 à 1,3 % en masse de Mg, 0,5 à 1,3 % en masse de Cr et 0,1 à 0,5 % en masse de Ti, le reste étant constitué par Al et des impuretés inévitables, dans lequel la quantité de Cu en tant qu'impureté inévitable est limitée à 0,2 % en masse ou moins.

7. Procédé de production de la pièce coulée en alliage d'aluminium selon la revendication 6, dans lequel la pièce coulée se fait par tout procédé parmi la coulée par gravité, la coulée basse pression, la coulée sous pression et le forgeage liquide.

8. Procédé de production de la pièce coulée en alliage d'aluminium selon la revendication 7, dans lequel un traitement thermique n'est pas réalisé après coulée.

9. Procédé de production de la pièce coulée en alliage d'aluminium selon la revendication 7, dans lequel après coulée, un traitement thermique en solution est réalisé à 510 à 530 °C pendant 2 à 5 heures, après quoi un vieillissement artificiel est réalisé à 160 à 200 °C pendant 4 à 8 heures.

10. Procédé de production selon l'une quelconque des revendications 6 à 9, dans lequel la pièce coulée en alliage d'aluminium est un carter pour un moteur électrique.
